# EUROPÄISCHE PATENTSCHRIFT

(11) **EP 1 705 795 B1**
(45) Veröffentlichungstag und Bekanntmachung des Hinweises auf die Patenterteilung: **29.12.2010**
(21) Anmeldenummer: 05015201.6
(22) Anmeldetag: 13.07.2005
(51) Int. Cl.: H03K 3/57

(54) **XRAM-Generator mit Öffnungsschalter**
XRAM generator with opening switch
Générateur XRAM avec commutateur de coupure

(30) Priorität: 24.03.2005 DE 102005014043
(43) Veröffentlichungstag der Anmeldung: 27.09.2006
(73) Patentinhaber: Deutsch-Französisches Forschungsinstitut Saint-Louis, 68301 Saint-Louis Cédex (FR)
(72) Erfinder: Brommer, Volker, 77815 Bühl (DE); Spahn, Emil, Dr., 79576 Weil am Rhein (DE)
(74) Vertreter: Schwabe - Sandmair - Marx

(56) Entgegenhaltungen:
- US-A- 4 613 765
- US-A- 4 642 476
- DIJK VAN E ED - COOPERSTEIN ET AL INSTITUTE OF ELECTRICAL AND ELECTRONICS ENGINEERS: "EXPERIMENTAL RESULTS OBTAINED WITH THE 1 MA RESONANT SERIES COUNTERPULSE OPENING SWITCH SYSTEM, DEVELOPED AT TNO" DIGEST OF TECHNICAL PAPERS OF THE 11TH IEEE INTERNATIONAL PULSED POWERCONFERENCE. BALTIMORE, MD, JUNE 29 - JULY 2, 1997, DIGEST OF TECHNICAL PAPERS OF THE INTERNATIONAL PULSED POWER CONFERENCE, NEW YORK, NY : IEEE, US, Bd. VOL. 1, 29. Juni 1997 (1997-06-29), Seiten 287-292, XP000861643 ISBN: 0-7803-4214-3
- KANTER M ET AL INSTITUTE OF ELECTRICAL AND ELECTRONICS ENGINEERS: "REPETITIVE OPERATION OF AN XRAM CIRCUIT" DIGEST OF TECHNICAL PAPERS OF THE INTERNATIONAL PULSED POWER CONFERENCE. ALBUQUERQUE, JUNE 21 - 23, 1993, NEW YORK, IEEE, US, Bd. VOL. 1 CONF. 9, 21. Juni 1993 (1993-06-21), Seiten 92-94, XP000531063 ISBN: 0-7803-1416-6
- WECK W ET AL: "Superconducting Inductive Pulsed Power Supply for Electromagnetic Launchers: Design Aspects and Experimental Investigation of Laboratory Set-up" IEEE TRANSACTIONS ON MAGNETICS, IEEE SERVICE CENTER, NEW YORK, NY, US, Bd. 33, Nr. 1, Januar 1997 (1997-01), Seiten 524-527, XP011031245 ISSN: 0018-9464

## Beschreibung

Die vorliegende Erfindung bezieht sich auf eine XRAM-Schaltung zum Erzeugen eines Stromimpulses durch ein Lastelement und insbesondere auf einen XRAM-Generator mit mindestens einem Öffnungsschalter nach dem Gegenstromverfahren.

Bei zahlreichen Anwendungen im Bereich der Kurzzeitphysik und Energieelektronik werden sehr schnelle Schaltelemente benötigt, um innerhalb sehr kurzer Zeiten im Bereich von zum Beispiel weniger als einer Mikrosekunde sehr hohe Ströme zum Beispiel oberhalb von 100 kA ein- bzw. ausschalten zu können, um zum Beispiel einen großen Stromimpuls im Zusammenwirken mit einem induktiven Energiespeicher zu erzeugen. Induktive Energiespeicher bieten aufgrund der hohen Energiedichte für Pulsstromversorgungen große Vorteile und können aus Stromquellen, wie zum Beispiel Batterien oder rotierenden Maschinen, welche zum Beispiel als Generatoren arbeiten, geladen werden. Durch angepasste Ladeund Entladevorgänge können hohe Repetitionsfolgen der Pulserzeugung erzielt werden, wobei die umzusetzende Energie während des Ladevorganges von der Stromquelle dem Induktivspeicher vergleichsweise langsam zugeführt wird. Um dann die vom induktiven Speicher aufgenommene Energie schlagartig in eine zu treibende Last zu transferieren, wird der Stromfluss im Speicherkreis mit Hilfe von öffnenden Schaltern unterbrochen.

Die Leistungsabgabe der zum Laden verwendeten Stromquellen ist vergleichsweise gering zu der letztendlich benötigten Leistung an der Last. Für das Beispiel eines Magnetdynamischen Speichers (MDS) liegt die maximale Leistungsabgabe nach dem derzeitigen Stand der Technik bei einigen MW, wobei sich die abgebbaren Stromstärken im Bereich unterhalb von 10 kA bei treibenden Spannungen von einigen 100 V befinden. In der Hochleistungs-Impulstechnik werden allerdings für verschiedene Applikationen Leistungen bzw. Ströme benötigt, die im Bereich von GW bzw. einigen 100 kA und darüber liegen können. Zu einer Pulserzeugung durch einen Induktivspeicher bedarf es somit einer Stromvervielfachung.

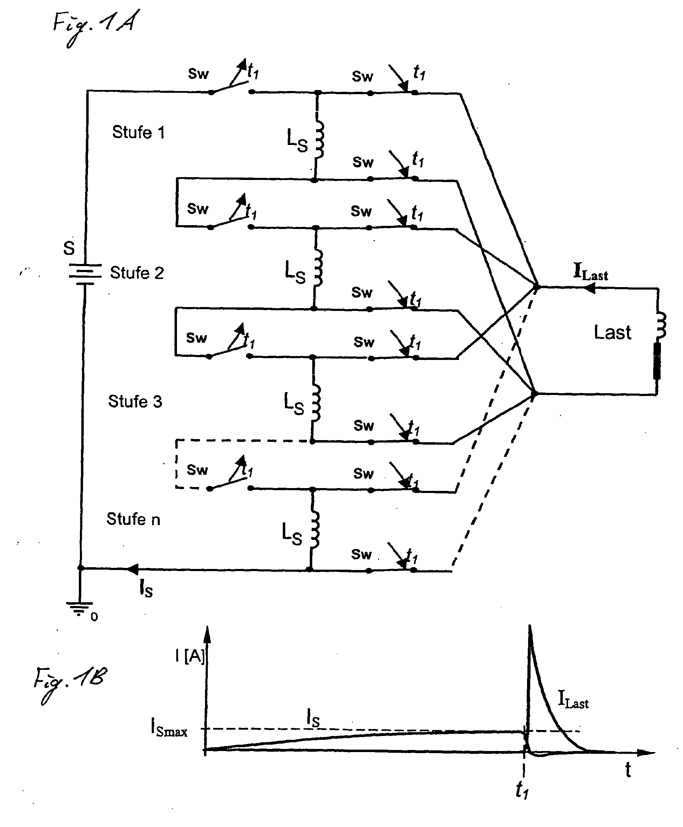

Eine Möglichkeit, einen Ladestrom zu vervielfachen, besteht in dem bekannten XRAM-Konzept, bei dem durch eine entsprechende Verschaltung zwei oder mehrere induktive Speicherspulen Lₛ in einer n Stufen enthaltenden Reihenschaltung "aufgeladen" werden, wie in Figur 1A gezeigt. Werden die Schalter, die die Induktivitäten verbinden, gleichzeitig zum Zeitpunkt t₁ geöffnet und wird ferner durch zusätzliche Kommutierungsschalter eine Verbindung zur Last hergestellt, so entladen sich die Speicherspulen Lₛ in einer nun angeordneten Parallelschaltung. Dabei addieren sich die Einzelströme der Teilspulen zum Gesamtstrom I_{Last}.

Figur 1B zeigt den Kurvenverlauf des Ladestromes Iₛ der Speicherspulen Lₛ und des Pulsstromes I_{Last} an der Last, welcher nach dem Schaltzeitpunkt t₁ steil ansteigt.

Ein Prototyp eines solchen induktiven Speichers nach dem XRAM-Prinzip wird von Weck W., Ehrhart P., Müller A., Reiner G. in "Superconducting Inductive Pulsed Power Supply for Electromagnetic Launchers, IEEE Transactions on Magnetics", Vol. 33, No. 1, January 1997 vorgestellt.

Die wesentliche Voraussetzung für das Funktionieren des oben beschriebenen Prinzips sind geeignete Öffnungsschalter, wie zum Beispiel mechanische Schalter, Gasentladungsschalter, supraleitende Schalter oder Halbleiterschalter. Dabei zeigen sich bei Halbleiterschaltern Vorteile, vor allem in Bezug auf Wartungsaufwand, Repetitionsrate und Lebensdauer.

Im Hinblick auf die Verwendung von Halbleiterschaltern in Verbindung mit dem XRAM-Prinzip wurden schon Untersuchungen mit GTO-Thyristoren als öffnende Schalter durchgeführt, wie zum Beispiel von M. Kanter, R. Cerny, N. Shaked, Z. Kaplan in "Repetitive Operation of an XRAM Circuit", Propulsion Physics Laboratory Soreq NRC, Yavne 70600, Israel und M. Kanter, S. Singer, R. Cemy, Z. Kaplan in "Multikilojoule Inductive Modulator with solid-state opening switches", IEEE Transactions on Power Electronics, Vol. 7, No. 2, April 1992 beschrieben. Für aktiv öffnende Halbleiterschalter, also zum Beispiel so genannte GTO-Thyristoren, MOSFET- oder IGBT-Elemente, ergeben sich jedoch im Vergleich zu herkömmlichen Thyristoren folgende Schwierigkeiten:

Während der Ladephase des induktiven Speichers müssen solche Schalter in der Lage sein, hohe Ströme im Bereich von mehreren kA über eine relativ lange Zeit von zum Beispiel 100 ms bis zu 10s zu führen und anschließend zuverlässig zu unterbrechen. Als entscheidende Größe tritt hier die Angabe des so genannten Lastintegrals ∫I²dt auf, das bei aktiv öffnenden Halbleiterschaltern gering ist im Vergleich zu Thyristoren. Insbesondere bei einem repetitiven Betrieb treten Schwierigkeiten hinsichtlich einer Überlastung auf.

Die Durchlasswiderstände bzw. die Verlustleistungen der aktiv öffnenden Schalter sind im Verglich zu Thyristoren höher. Deshalb ist vor allem bei einer Reihenschaltung von mehreren Schaltern die Summe der Verlustleistungen nicht unerheblich.

Beim Abschalten entstehen durch die vorhandenen Leitungsinduktivitäten bzw. durch die Lastinduktivität aufgrund des Stromanstieges an der Last Spannungen, die an den Öffnungsschaltem anliegen. Werden sehr steile Stromanstiege von zum Beispiel mehr als 1 kA/µs an der Last benötigt, entstehen an den Schaltern schnell hohe Spannungen im kV-Bereich, die deren Spannungsfestigkeit übersteigen. Diesen Schaltspannungen ist entweder mit einer Reihenschaltung oder mit aufwändigen Dämpfungsgliedern zu begegnen, wobei jede dieser Maßnahmen entsprechende Nachteile mit sich bringt.

Alle beteiligten aktiv öffnenden Schalter müssen durch elektronische Einheiten angesteuert werden, wobei der Schaltungsaufwand seitens der Steuerelektronik mit der Anzahl der beteiligten Öffnungsschalter steigt. Ferner können bei solchen Ansteuerungen Probleme mit Schaltverzug (Jitter) einzelner Komponenten auftreten.

In dem Aufsatz "Experimental Results Obained with the 1 MA Resonant Series Counterpulsed Opening Switch Sytem, developed at TNO" Edwin van Dijk, Labaroty for Power Electronics and Electrical Machines, Digest of technical papers of the 11th IEEE International Pulsed Powerconference, Baltimore, MD, Juni 29 bis Juli 2, 1997, Digest of technical papers of the International Pulsed Powerconference, New York, NY: IEEE, US, Bd. VOL. 1, 29. Juni 1997, Seiten 287-292, XP 000861643 ist eine Schaltung zur kontrollierten Unterbrechung sehr hoher Ströme in gepulsten Leistungssystemen mit induktivem Speicher bekannt, wobei ein mechanischer Öffnungsschalter zur Unterbrechung der hohen Ströme eingesetzt wird.

Es ist eine Aufgabe der vorliegenden Erfindung eine XRAM-Schaltung und ein Verfahren zum Erzeugen eines Stromimpulses mittels einer XRAM-Schaltung vorzuschlagen, welche das einfache Unterbrechen eines Ladestromes ermöglichen.

Diese Aufgabe wird durch eine XRAM-Schaltung und ein Verfahren wie in den unabhängigen Ansprüchen definiert gelöst. Vorteilhafte Ausführungsformen ergeben sich aus den abhängigen Ansprüchen.

Eine erfindungsgemäße XRAM-Schaltung zum Erzeugen eines Stromimpulses durch ein Lastelement weist auf: mindestens einen Primärenergiespeicher, wie zum Beispiel eine durch eine Batterie, einen Akkumulator oder einen Generator gebildete Stromquelle, bevorzugt eine Gleichstromquelle und mindestens einen Sekundärenergiespeicher, wie z.B. ein induktives Element oder eine Speicherspule, welche von dem Primärenergiespeicher aufgeladen, also z.B. mit einem Stromfluss beaufschlagt werden kann, mindestens ein Öffnungsschaltelement, wie z.B. einen Thyristor, IGBT, GTO, MOSFET oder einen anderen Halbleiterschalter , der oder das bevorzugt leistungslos abgeschaltet werden kann, mit welchem eine Verbindung des Primärenergiespeichers mit dem mindestens einen Sekundärenergiespeicher nach dem Aufladen unterbrochen oder zum Aufladen hergestellt werden kann und mindestens einen Schließschalter, wie z.B. einen Thyristor, Funkenstreckenschalter, oder einen schnellen mechanischen Schalter mit welchem eine Verbindung zwischen dem mindestens einen Sekundärenergiespeicher und einem Lastelement wie z.B. einem Induktorsystem eines elektromagnetischen Werfers, hergestellt oder unterbrochen werden kann, gekennzeichnet durch mindestens ein Gegenstromelement, wie z.B. einen Kondensator, der z.B. während des Ladens des oder der Sekundärenergiespeicher so aufgeladen wird, dass er beim Entladen z.B. nach dem Verbinden des Sekundärenergiespeichers mit einer Last einen Gegenstrom zu dem Ladestrom durch das mindestens eine Öffnungsschaltelement erzeugt und welcher so mit dem mindestens einen Öffnungsschaltelement verbunden ist, dass von dem mindestens einen Gegenstromelement ein gegen den Ladestrom gerichteter Gegenstrom durch das mindestens eine Öffnungsschaltelement fließt, wenn z.B. der Schließschalter geschlossen wird, so dass jeder Sekundärenergiespeicher bevorzugt leistungslos vom Primärenergiespeicher getrennt werden kann.

Vorzugsweise ist mindestens ein Hilfsschalter, wie z.B. eine Diode, antiparallel zu dem z.B. durch einen Thyristor gebildeten Öffnungsschalter geschaltet, um den Gegenstrom nach dem Stromnulldurchgang zu übernehmen und den Thyristor leistungslos zu unterbrechen.

Bevorzugt ist die Schaltung mehrstufig aufgebaut und weist mehrere, also z.B. zwei, drei oder mehr als drei Sekundärenergiespeicher mit jeweils zugeordneten Öffnungsschaltern und Gegenstromelementen auf, wobei die Sekundärenergiespeicher mit den Öffnungsschaltem während des Ladevorgangs in Reihe geschaltet mit z.B. einer Stromquelle verbunden sind und zum Entladen parallel zu der Last geschaltet werden können, wobei in jedem dieser dann parallel geschalteten Stromkreise mindestens ein Stromrichtungselement, wie z.B. eine Diode, und vorteilhaft auch jeweils mindestens ein Gegenstromelement vorgesehen ist, welches z.B. parallel zu einem Stromrichtungselement geschaltet sein kann.

Die Erfindung bezieht sich weiterhin auf einen an sich bekannten elektromagnetischen Werfer oder eine mit einem gepulsten Strom betriebene Last mit einer wie oben beschriebenen XRAM-Schaltung zur Ansteuerung der Werferspulen bzw. eines Induktorsystems bzw. der Last.

Bei einem erfindungsgemäßen Verfahren zum Erzeugen eines Stromimpulses durch ein Lastelement mittels einer XRAM-Schaltung wird mindestens ein Sekundärenergiespeicher von einem Primärenergiespeicher aufgeladen, wobei das Lastelement während des Aufladevorganges im Wesentlichen von dem Sekundärenergiespeicher getrennt ist, also z.B. der Schließschalter geöffnet ist bzw. sich ein Halbleiterschalter im sperrenden Zustand befindet und nach dem Verbinden des Lastelements mit dem mindestens einen Sekundärenergiespeicher ein Gegenstrom von z.B. einem Kondensator durch mindestens einen Öffnungsschalter erzeugt wird, welcher den mindestens einen Sekundärenergiespeicher mit dem Primärenergiespeicher verbindet, so dass der Öffnungsschalter z.B. leistungslos geöffnet werden kann oder sich selbst in einen sperrenden Zustand versetzt, da z.B. ein Haltestrom unterschritten wird.

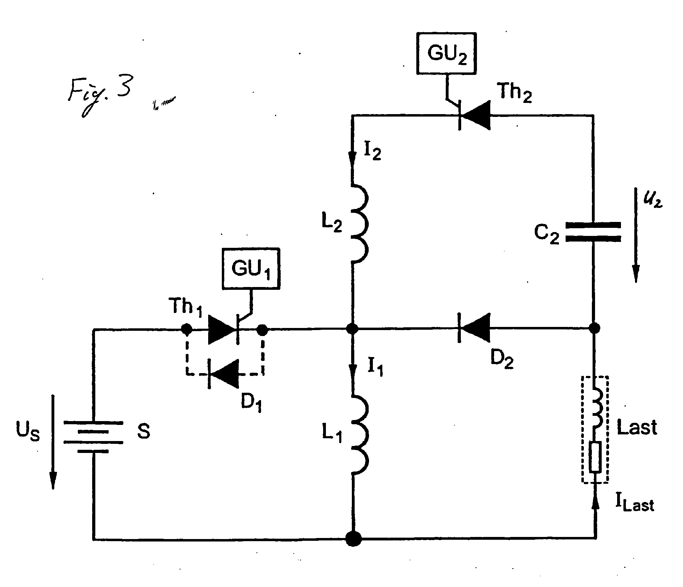

Somit wird erfindungsgemäß das bekannte XRAM-Konzept durch die Verwendung von Öffnungsschaltern, wie zum Beispiel Thyristoren, welche nach dem Gegenstromverfahren abgeschaltet werden können, verbessert. Dabei wird der Gegenstromkreis vorteilhaft so konzipiert, dass der Gegenstromimpuls direkt über die Last geführt wird, wie in Figur 3 beispielhaft gezeigt. Der Gegenstromimpuls fließt somit sowohl über den Primärenergiespeicher S, als auch zusätzlich über die Last, so dass hier im Bedarfsfall ein sehr hoher Stromgradient dI_{Last/}dt realisiert werden kann, der sich durch die Kapazität C₂ kontrollieren bzw. vorgeben lässt, wobei der Spannungsabfall am Hauptthyristor Th₁ während der kritischen Schaltphase minimal bleibt.

Grundsätzlich besteht die Möglichkeit, die Amplitude des Gegenstroms absichtlich überzudimensionieren, sodass dem Stromimpuls in dem Lastkreis ein Gegenstrom überlagert wird, was je nach Art der Last einen Vorteil bieten kann. Soll zum Beispiel eine aktive elektromagnetische Schutzeinrichtung gespeist werden, so ist es vorteilhaft diese unmittelbar nach ihrer Initiierung mit einem möglichst hohen Stromimpuls bei möglichst steiler Stromanstiegsrate zu beaufschlagen.

Der zeitliche Verlauf des Gegenstromimpulses kann in weiten Grenzen auch an bestimmte Anforderungen angepasst werden. So lassen sich beispielsweise mehrere parallel geschaltete Gegenstromzweige verwenden, die sequentiell mit geringem zeitlichem Versatz gezündet werden. Der so entstehende stufenförmige Gegenstrom ist zum Beispiel vorteilhaft, wenn für den Hauptthyristor Th₁ nur Exemplare mit relativ großer Rekombinationszeit zur Verfügung stehen. Im Gegenzug bietet diese Maßnahme den Vorteil, dass sich das Gegenstromintegral minimieren lässt und somit die Energie im Kondensator C₂ bestmöglich genutzt wird. Durch diese im Vergleich zur Überdimensionierung entgegengesetzte Vorgehensweise ergibt sich ein sehr viel breiteres und flexibleres Anwendungsspektrum.

Die Erfindung wird nachfolgend anhand einer bevorzugten Ausfübrungsform beschrieben. Es zeigen:
- Figur 1A: eine Prinzipschaltung nach dem XRAM-Prinzip;
- Figur 1B: den Kurvenverlauf des Ladestroms der Speicherspulen und des Pulsstro- mes an der Last;
- Figur 2: eine Ausführungsform einer erfindungsgemäßen XRAM-Schaltung mit Thyristoren als Öffnungsschalter nach dem Gegenstromprinzip; und
- Figur 3: eine Schaltungsvariante eines Öffnungsschalters, bei welcher der Gegen- stromimpuls über die Last geführt werden kann.

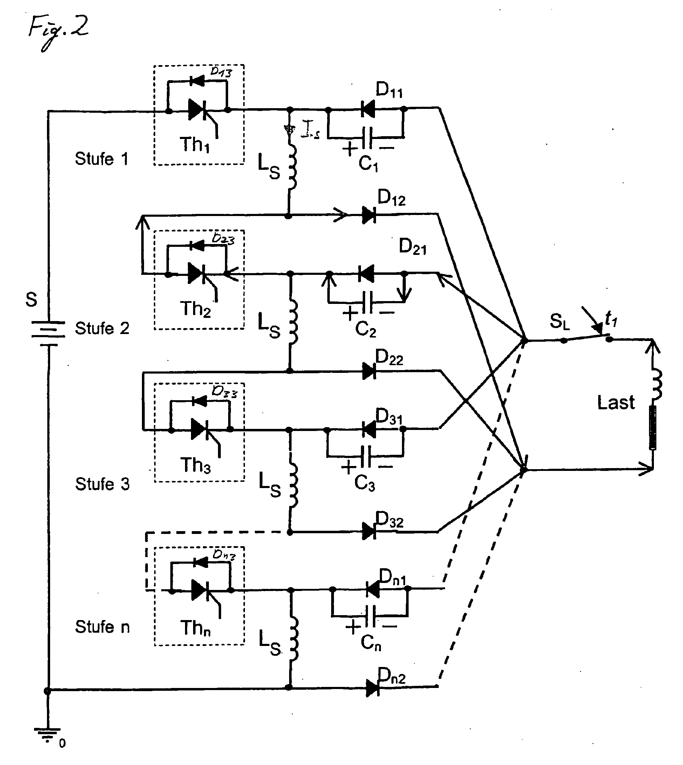

Figur 2 zeigt eine Ausführungsform einer erfindungsgemäßen XRAM-Schaltung mit n Stufen, wobei mit Hilfe eines Schließschalters S_{L}, der bei dieser Variante aus einem schnellen, leistungsstarken Thyristor oder auch aus einem Funkenstreckenschalter bestehen kann, die geladenen Hilfskondensatoren C₁ bis Cₙ, die über den Dioden D₁₁ bis Dₙ₁ angeordnet sind, gleichzeitig entladen werden, sobald im Magnetfeld der n Speicherspulen Lₛ die gewünschte Energie E = n · ½ LₛI_{S}² bereit steht. Der Weg des Entladestromes der Stufe 2 ist in Figur 2 durch Pfeile gekennzeichnet. Dieser Strom fließt in Rückwärtsrichtung durch den zu öffnenden Schalter, welcher in der Ausführungsform durch einen Thyristor Th₂ gebildet wird bzw. nach dem Stromnulldurchgang durch einen Hilfsschalter, der vorzugsweise aus einer antiparallelen Diode D₂₃ besteht. In dieser Phase der Stromübemahme durch die antiparallele Diode D₂₃ kann der Schalter Th₂ leistungslos unterbrochen werden. Bei der Verwendung eines Thyristors als Öffnungsschalter wird dieser durch Unterschreitung des Haltestromes in Verbindung mit der so genannten Freiwerdezeit in den Sperrzustand versetzt. Allgemein können jedoch statt Thyristoren auch andere Schalter verwendet werden, welche während der Gegenstromphase und insbesondere nach dem Stromnulldurchgang, z.B. nach der Übernahme des Stromes durch den Hilfsschalter, leistungslos abgeschaltet werden können.

Dieser Vorgang findet in jeder Stufe statt und die einzelnen Gegenströme addieren sich an der Last. Technisch gesehen ist es vorteilhaft die Stromkreise für die jeweiligen Stufen der Gegenströme identisch aufzubauen, also zum Beispiel so, dass diese die gleiche Impedanz aufweisen. Eine Ausnahme bildet lediglich der Gegenstromkreis, der aus dem ersten Thyristor Th₁ und der speisenden Stromquelle S gebildet wird. Je nach Höhe der Impedanz dieses Quellkreises kann durch Variation der Ladespannung an dem Hilfskondensator C₁ oder durch Änderung dessen Kapazitätswertes der Gegenstrompuls eingestellt werden.

Sobald die Thyristoren Th₁ bis Thₙ abgeschaltet sind, geben die induktiven Speicherspulen Lₛ, die nun parallel angeordnet sind, mit Hilfe der Schaltdioden D₁₁, D₁₂, ... Dₙ₂ den Strom an die Last ab. Der Laststrom setzt sich also zunächst aus dem Gegenstrom und anschließend aus dem Strom, den die Speicherspulen L₅ der n Stufen liefern, zusammen.

Das Prinzip des XRAM-Generators mit öffnenden Schaltern, insbesondere Halbleiterschaltern, nach dem Gegenstromverfahren bringt folgende Vorteile mit sich:

Mit dem beschriebenen Schaltprinzip kann der große Vorteil der geringen Verlustleistungen und der hohen Belastbarkeit von Thyristoren verglichen mit den aktiv öffnenden Halbleiterschaltern, sofern diese als öffnende Schalter eingesetzt werden, genutzt werden. Auch ein repetitiver Betrieb eines XRAM-Generators mit einer solchen Verschaltung ist einfach realisierbar.

Es entstehen keine Schaltspannungen über den Öffnungsschaltern, also zum Beispiel den im Ausführungsbeispiel verwendeten Thyristoren Th₁, Th₂,...Thₙ. Während der Gegenstromphase, die zeitgleich mit dem Stromanstieg an der Last einhergeht, fließt der Strom durch die Schalter Th₁, Th₂, ... Thₙ, wodurch sich diese noch im leitenden Zustand befinden. Dadurch fällt an den Komponenten keine Spannung ab, womit in dieser Phase beliebig hohe Stromsteilheiten und Spannungsspitzen an der Last erlaubt sind.

Wenn die Schalter Th₁, Th₂,...Thₙ abgeschaltet sind, ist der kritische Bereich der Schaltphase schon überwunden, was bedeutet, dass an den Schaltern hauptsächlich nur noch die ohmschen Spannungsverluste des Lastkreises abfallen. Aufwendige Reihenschaltungen der Schaltkomponenten oder Dämpfungsglieder sind dadurch nicht erforderlich.

Die Energie der Hilfskondensatoren C₁ bis Cₙ wird vollständig in die Last übertragen und addiert sich zur induktiven Energie, die die Speicherspulen L₅ an die Last abgeben.

Bei zwangsabgeschalteten Schaltern durch Gegenstrom entstehen keinerlei Probleme mit Schaltverzug (Jitter) der einzelnen Komponenten, da diese zwangsweise über einen einzigen Schließschalter S_{L} abgeschaltet werden. Diese Einfachheit der Schaltung ermöglicht erhebliche Einsparungen bei der Steuerelektronik.

Eine konkrete Anwendung dieses Schaltprinzips liegt im militärischen Bereich, zum Beispiel bei der elektromagnetischen Beschleunigung und beim elektrothermisch-chemischen Antrieb. Im zivilen Bereich ist der Einsatz solcher Pulsgeneratoren für alle Applikationen denkbar, bei denen eine Erzeugung von elektrischen Plasmen erforderlich ist.

## Patentansprüche

1. XRAM-Schaltung zum Erzeugen eines Stromimpulses durch ein Lastelement, wobei die Schaltung aufweist:
mindestens einen Primärenergiespeicher (S),
mindestens einen Sekundärenergiespeicher (Lₛ), welcher von dem Primärenergiespeicher (S) aufgeladen werden kann,
mindestens ein Öffnungsschaltelement (Th₁, Th₂,...Thₙ), mit welchem eine Verbindung des Primärenergiespeichers (S) mit dem mindestens einen Sekundärenergiespeicher (Lₛ) unterbrochen oder hergestellt werden kann,
wobei der Öffnungsschalter ein Halbleiterschalter, ein Thyristor, ein IGBT, ein GTO oder ein MOSFET ist, und
einen Schließschalter (S_{L}), mit welchem eine Verbindung zwischen dem mindestens einen Sekundärenergiespeicher (L_{S}) und einem Lastelement hergestellt oder unterbrochen werden kann, und
mindestens ein Gegenstromelement (C₁, C₂,...Cₙ), welches so mit dem mindestens einen Öffnungsschaltelement (Th₁, Th₂,...Thₙ) verbunden ist, dass ein Gegenstrom von dem mindestens einen Gegenstromelement (C₁, C₂,... Cₙ) **durch** das mindestens eine Öffnungsschaltelement (Th₁, Th₂,...Thₙ) fließt, wenn der Schließschalter (S_{L}) geschlossen wird.

2. Schaltung nach Anspruch 1, wobei der Primärenergiespeicher (S) eine Stromquelle, oder eine Gleichstromquelle und insbesondere ein Generator, eine Batterie oder ein Akkumulator ist.

3. Schaltung nach einem der vorhergehenden Ansprüche, wobei der mindestens eine Sekundärenergiespeicher ein induktives Element und insbesondere eine Speicherspule (Lₛ) ist.

4. Schaltung nach einem der vorhergehenden Ansprüche, wobei das mindestens eine Gegenstromelement ein kapazitives Element und bevorzugt einen Kondensator (C₁, C₂ .... Cₙ) ist.

5. Schaltung nach einem der vorhergehenden Ansprüche, wobei der Schließschalter (S_{L}) ein Thyristor, Funkenstreckenschalter, oder ein schnelle mechanischer Schalter ist.

6. Schaltung nach einem der vorhergehenden Ansprüche, wobei mindestens ein Hilfsschalter und bevorzugt ein Stromrichtungselement, insbesondere eine Diode (D₁₃, D₂₃.... Dₙ₃), parallel zu dem mindestens einen Öffnungsschaltelement (Th₁, Th₂,... Thₙ) geschaltet ist.

7. Schaltung nach einem der vorhergehenden Ansprüche, wobei die Schaltung mehrstufig aufgebaut ist und mindestens zwei Sekundärenergiespeicher (Lₛ), mindestens zwei Öffnungsschaltelemente (Th₁, Th₂,... Thₙ) und mindestens zwei Gegenstromelemente (C₁, C₂,... Cₙ) aufweist, wobei jeweils ein Sekundärenergiespeicher (L_{S}) mit einem zugehörigen Öffnungsschaltelement (Th₁, Th₂,... Thₙ) in Serie und mit mindestens einem weiteren Sekundärenergiespeicher (Lₛ) und mindestens einem weiteren Öffnungsschaltelement (Th₁, Th₂,... Thₙ) in Serie geschaltet ist und jeweils ein Gegenstromelement (C₁, C₂,... Cₙ) mit jeweils einem Öffnungsschaltelement (Th₁, Th₂,... Thₙ) verbunden ist.

8. Schaltung nach einem der vorhergehenden Ansprüche mit einem Lastelement.

9. Schaltung nach einem der vorhergehenden Ansprüche, wobei mindestens ein Stromrichtungselement und bevorzugt mindestens eine Diode (D₁₁, D₂₁,... Dₙ₁; D₁₂, D₂₂,... Dₙ₂) so mit dem mindestens einem Sekundärenergiespeicher (L_{S}) verbunden ist, so dass ein Strom von dem mindestens einen Sekundärenergiespeicher (L_{S}) nach dem Schließen des Schließschalters (S_{L}) durch ein Lastelement fließen kann und ein Stromfluss in Gegenrichtung gesperrt wird.

10. Schaltung nach einem der vorhergehenden Ansprüche, wobei mindestens ein Stromrichtungselement und bevorzugt eine Diode (D₁₁, D₂₁,... Dₙ₁) parallel zu dem mindestens einen Gegenstromelement (C₁, C₂,....Cₙ) geschaltet ist.

11. Schaltung nach einem der vorhergehenden Ansprüche mit einer Steuereinheit zum Ansteuern des mindestens einen Öffnungschaltelements (Th₁, Th₂,... Thₙ) und/oder des Schließschalters (S_{L}).

12. Vorrichtung zur elektromagnetischen Beschleunigung eines Körpers mit einer Schaltung nach einem der vorhergehenden Ansprüche und einem ein Magnetfeld erzeugenden Lastelement, mit welchem ein Magnetfeld zur Beschleunigung des Körpers erzeugt werden kann.

13. Vorrichtung zur Erzeugung von elektrischen Plasmen mit einer Schaltung nach einem der Ansprüche 1 bis 12 und einem ein Plasma erzeugendes Lastelement.

14. Verfahren zum Erzeugen eines Stromimpulses durch ein Lastelement mittels einer XRAM-Schaltung, wobei mindestens ein Sekundärenergiespeicher (L_{S}) von einem Primärenergiespeicher (S) aufgeladen wird und das Lastelement während des Aufladevorganges im Wesentlichen von dem Sekundärenergiespeicher (L_{S}) getrennt ist und nach dem Verbinden des Lastelements mit dem mindestens einen Sekundärenergiespeicher (L_{S}) ein Gegenstrom durch mindestens einen Halbleiter-Öffnungsschalter (Th₁, Th₂,... Thₙ) erzeugt wird, welcher den mindestens einen Sekundärenergiespeicher (L_{S}) mit dem Primärenergiespeicher (S) verbindet, so dass der Halbleiter-Öffnungsschalter (Th₁, Th₂,... Thₙ) bevorzugt im lastfreien Zustand geöffnet werden kann oder sich selbst in einen sperrenden Zustand versetzt.

## Claims

1. An XRAM circuit for producing a current pulse through a load element, wherein the circuit comprises:
at least one primary energy storage unit (S);
at least one secondary energy storage unit (Lₛ) which can be charged up by the primary energy storage unit (S);
at least one opening switching element (Th₁, Th₂,...Thₙ) using which a connection between the primary energy storage unit (S) and the at least one secondary energy storage unit (Lₛ) can be interrupted or established, wherein the opening switch is a semiconductor switch, a thyristor, an IGBT, a GTO or a MOSFET;
a closing switch (S_{L}), using which a connection between the at least one secondary energy storage unit (Lₛ) and a load element can be established or interrupted; and
at least one counter current element (C₁, C₂,...Cₙ) which is connected to the at least one opening switching element (Th₁, Th₂,...Thₙ) such that a counter current flows from the at least one counter current element (C₁, C₂,...Cₙ) through the at least one opening switching element (Th₁, Th₂,...Thₙ) when the closing switch (S_{L}) is closed.

2. The circuit according to claim 1, wherein the primary energy storage unit (S) is a current source or a direct current source and in particular a generator, a battery or an accumulator.

3. The circuit according to any one of the preceding claims, wherein the at least one secondary energy storage unit is an inductive element and in particular a storage coil (Lₛ).

4. The circuit according to any one of the preceding claims, wherein the at least one counter current element is a capacitive element and preferably a capacitor (C₁, C₂,...Cₙ).

5. The circuit according to any one of the preceding claims, wherein the closing switch (S_{L}) is a thyristor, air-gap switch or a fast mechanical switch.

6. The circuit according to any one of the preceding claims, wherein at least one auxiliary switch and preferably a current direction element, in particular a diode (D₁₃, D₂₃...Dₙ₃), is connected in parallel with the at least one opening switching element (Th₁, Th₂,...Thₙ).

7. The circuit according to any one of the preceding claims, wherein the circuit is constructed in multiple stages and comprises at least two secondary energy storage units (Lₛ), at least two opening switching elements (Th₁, Th₂,...Thₙ) and at least two counter current elements (C₁, C₂,...Cₙ), wherein each secondary energy storage unit (Lₛ) is connected in series to a corresponding opening switching element (Th₁, Th₂,...Thₙ) and is connected in series to at least one other secondary energy storage unit (L_{S}) and to at least one other opening switching element (Th₁, Th₂,...Thₙ), and each counter current element (C₁, C₂,...Cₙ) is respectively connected to one opening switching element (Th₁, Th₂,...Thₙ).

8. The circuit according to any one of the preceding claims, comprising a load element.

9. The circuit according to any one of the preceding claims, wherein at least one current direction element and preferably at least one diode (D₁₁, D₂₁,...Dₙ₁; D₁₂, D₂₂,...Dₙ₂) is connected to the at least one secondary energy storage unit (Lₛ) such that a current can flow from the at least one secondary energy storage unit (L_{S}) through a load element after the closing switch (S) is closed, and a flow of current in the opposite direction is blocked.

10. The circuit according to any one of the preceding claims, wherein at least one current direction element and preferably a diode (D₁₁, D₂₁,...Dₙ₁) is connected in parallel with the at least one counter current element (C₁, C₂,...Cₙ).

11. The circuit according to any one of the preceding claims, comprising a control unit for controlling the at least one opening switching element (Th₁, Th₂,...Thₙ) and/or the closing switch (S_{L}).

12. A device for electromagnetically accelerating a body, comprising a circuit according to any one of the preceding claims and a magnetic field producing load element using which a magnetic field can be produced in order to accelerate the body.

13. A device for producing electrical plasmas, comprising a circuit according to any one of claims 1 to 12 and a plasma producing load element.

14. A method for producing a current pulse through a load element by means of an XRAM circuit, wherein at least one secondary energy storage unit (Lₛ) is charged up by a primary energy storage unit (S), and the load element is essentially separated from the secondary energy storage unit (L_{S}) during the charge-up sequence, and after the load element is connected to the at least one secondary energy storage unit (L_{S}), a counter current is produced through at least one semiconductor opening switch (Th₁, Th₂,...Thₙ) which connects the at least one secondary energy storage unit (L_{S}) to the primary energy storage unit (S), such that the semiconductor opening switch (Th₁, Th₂,...Thₙ) can preferably be opened at zero load or switches to its blocking state.

## Revendications

1. Circuit XRAM pour générer une impulsion de courant par l'intermédiaire d'un élément de charge, le circuit comportant :
au moins un accumulateur d'énergie primaire (S),
au moins un accumulateur d'énergie secondaire (Lₛ) qui peut être chargé par l'accumulateur d'énergie primaire (S),
au moins un élément de commutation d'ouverture (Th₁, Th₂, ... Thₙ) au moyen duquel une liaison entre l'accumulateur d'énergie primaire (S) et le au moins un accumulateur d'énergie secondaire (Lₛ) peut être interrompue ou établie,
dans lequel le commutateur d'ouverture est un commutateur à semi-conducteurs, un thyristor, un IGBT, un GTO ou un MOSFET, et
un commutateur de fermeture (S_{L}) au moyen duquel une liaison entre le au moins un accumulateur d'énergie secondaire (Lₛ) et un élément de charge peut être établie ou interrompue, et
au moins un élément de contre-courant (C₁, C₂, ... Cₙ) qui est relié au au moins un élément de commutation d'ouverture (Th₁, Th₂, ... Thₙ) de telle sorte qu'un contre-courant provenant du au moins un élément de contre-courant (C₁, C₂, ... Cₙ) circule à travers le au moins un élément de commutation d'ouverture (Th₁, Th₂, ... Thₙ) lorsque le commutateur de fermeture (S_{L}) est fermé.

2. Circuit selon la revendication 1, dans lequel l'accumulateur d'énergie primaire (S) est une source de courant ou une source de courant continu, et en particulier un générateur, une batterie ou un accumulateur.

3. Circuit selon l'une quelconque des revendications précédentes, dans lequel le au moins un accumulateur d'énergie secondaire est un élément inductif et en particulier une bobine d'accumulation (Lₛ).

4. Circuit selon l'une quelconque des revendications précédentes, dans lequel le au moins un élément de contre-courant est un élément capacitif et de préférence un condensateur (C₁, C₂, ... Cₙ).

5. Circuit selon l'une quelconque des revendications précédentes, dans lequel le commutateur de fermeture (S_{L}) est un thyristor, un commutateur d'éclateur ou un commutateur mécanique rapide.

6. Circuit selon l'une quelconque des revendications précédentes, dans lequel au moins un commutateur auxiliaire, et de préférence un élément de direction de courant, en particulier une diode (D₁₃, D₂₃, ... Dₙ₃), est raccordé en parallèle au au moins un élément de commutation d'ouverture (Th₁, Th₂, ... Thₙ).

7. Circuit selon l'une quelconque des revendications précédentes, dans lequel le circuit est construit en plusieurs étages et comporte au moins deux accumulateurs d'énergie secondaires (Lₛ), au moins deux éléments de commutation d'ouverture (Th₁, Th₂, ... Thₙ) et au moins deux éléments de contre-courant (C₁, C₂, ... Cₙ), dans lequel chaque accumulateur d'énergie secondaire (Lₛ) est raccordé en série à un élément de commutation d'ouverture correspondant (Th₁, Th₂, ... Thₙ) et est raccordé en série à au moins un autre accumulateur d'énergie secondaire (Lₛ) et à au moins un autre élément de commutation d'ouverture (Th₁, Th₂, ... Thₙ), et chaque élément de contre-courant (C₁, C₂, ... Cₙ) est respectivement relié à un élément de commutation d'ouverture (Th₁, Th₂, ... Thₙ).

8. Circuit selon l'une quelconque des revendications précédentes, comportant un élément de charge.

9. Circuit selon l'une quelconque des revendications précédentes, dans lequel au moins un élément de direction de courant, et de préférence au moins une diode (D₁₁, D₂₁, ··· Dₙ₁; D₂₁, D₂₂, ... Dₙ₂), est raccordé au au moins un accumulateur d'énergie secondaire (Lₛ) de telle sorte qu'un courant provenant du au moins un accumulateur d'énergie secondaire (Lₛ) peut circuler à travers un élément de charge après la fermeture du commutateur de fermeture (S_{L}) et une circulation de courant en sens inverse est bloquée.

10. Circuit selon l'une quelconque des revendications précédentes, dans lequel au moins un élément de direction de courant, et de préférence une diode (D₁₁, D₂₁, ... Dₙ₁), est raccordé en parallèle au au moins un élément de contre-courant (C₁, C₂, ... Cₙ).

11. Circuit selon l'une quelconque des revendications précédentes, comportant une unité de commande pour commander le au moins un élément de commutation d'ouverture (Th₁, Th₂, ... Thₙ) et/ou le commutateur de fermeture (S_{L}).

12. Dispositif pour accélérer électromagnétiquement un corps comportant un circuit selon l'une quelconque des revendications précédentes et un élément de charge générant un champ magnétique, au moyen duquel un champ magnétique peut être généré pour accélérer le corps.

13. Dispositif pour générer des plasmas électriques, comportant un circuit selon l'une quelconque des revendications 1 à 12 et un élément de charge générant un plasma.

14. Procédé pour générer une impulsion de courant à travers un élément de charge au moyen d'un circuit XRAM, comportant les étapes consistant à charger au moins un accumulateur d'énergie secondaire (Lₛ) à partir d'un accumulateur d'énergie primaire (S) et séparer sensiblement l'élément de charge de l'accumulateur d'énergie secondaire (Lₛ) pendant la séquence de charge, et après le raccordement de l'élément de charge au au moins un accumulateur d'énergie secondaire (Lₛ), générer un contre-courant par l'intermédiaire d'au moins un commutateur d'ouverture à semi-conducteurs (Th₁, Th₂, ... Thₙ) qui relie le au moins un accumulateur d'énergie secondaire (Lₛ) à l'accumulateur d'énergie primaire (S) de telle sorte que le commutateur d'ouverture à semi-conducteurs (Th₁, Th₂, ... Thₙ) peut être ouvert de préférence à l'état sans charge ou se place lui-même dans un état bloquant.
